(19) Europäisches Patentamt

European Patent Office

Office européen des brevets

(11) EP 1 655 784 A2

(12) EUROPEAN PATENT APPLICATION

(43) Date of publication:
10.05.2006 Bulletin 2006/19

(51) Int Cl.:
H01L 29/78 (2006.01)          H01L 29/08 (2006.01)
H01L 21/336 (2006.01)

(21) Application number: 05023672.8

(22) Date of filing: 28.10.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 29.10.2004 JP 2004316898

(71) Applicant: SHARP KABUSHIKI KAISHA
Osaka-shi, Osaka 545-8522 (JP)

(72) Inventor: Adan, Alberto O.
Ikoma-shi
Nara 630-0141 (JP)

(74) Representative: Müller - Hoffmann & Partner
Patentanwälte,
Innere Wiener Strasse 17
81667 München (DE)

(54) **Trench MOSFET and method of manufacturing the same**

(57) A trench MOSFET of the present invention has a trench region (6) in a semiconductor body. The semiconductor body contains: a substrate (1) which is a p-type heavily doped drain region; an epitaxial layer (2) which is a p-type lightly doped drain region; a n-type body region (3); and a p-type source diffusion region (7), the regions being formed in this order. The source diffusion region is insulated from the trench region and covers the trench region. The trench MOSFET has a reduced ON resistance.

# FIG. 1

**Description**

FIELD OF THE INVENTION

The present invention relates in general to the structure of a semiconductor device and its manufacturing method and in particular to a trench MOSFET (metal oxide semiconductor field effect transistor) and its manufacturing method, the trench MOSFET having useful applications in power supply devices, such as DC-DC converters and high-side load drives.

BACKGROUND OF THE INVENTION

Vertical trench MOSFETs (hereinafter "trench MOSs" where appropriate) have been traditionally used a lot in power supply control electronics to exploit their structural efficiency and low ON resistance.

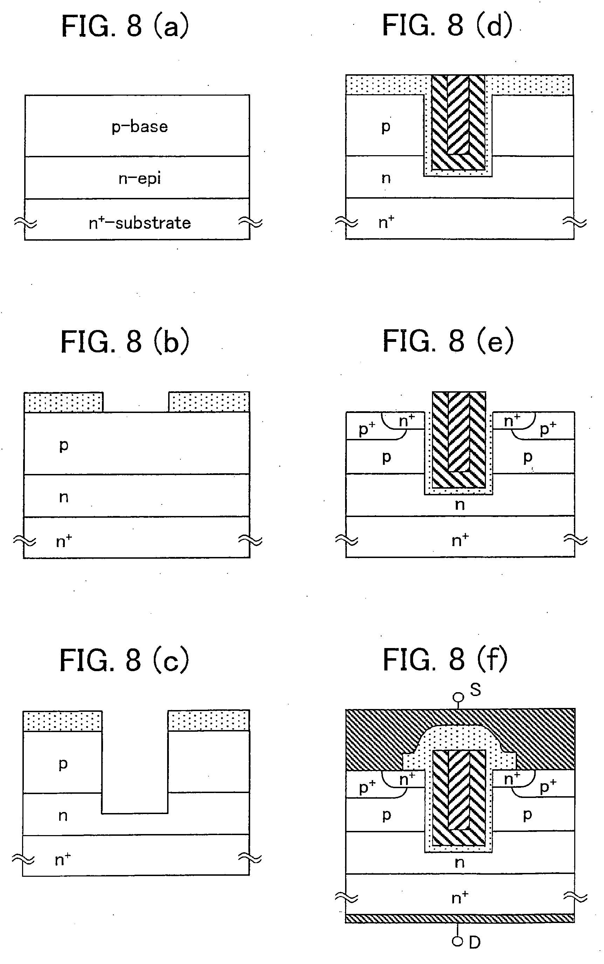

Figures 8(a) to 8(f) are cross-sectional views illustrating manufacturing steps of a conventional, typical n-channel trench MOSFET. See, for example, Optimized Trench MOSFET Technologies for Power Devices by Krishna Shenai, IEEE Transactions on Electron Devices, Vol. 39, No. 6, pp. 1435-1443, June 1992). The trench MOSFET has two important parameters (key parameter) among others: (a) breakdown voltage (hereinafter, "BVdss" where appropriate) and (b) ON resistance (hereinafter, "$R_{ON}$" where appropriate).

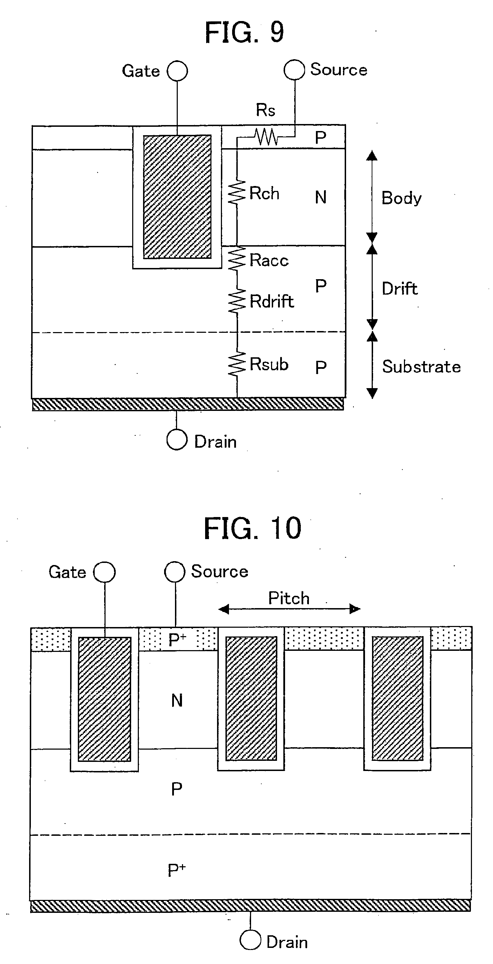

Figure 9 shows a physical configuration of components of a MOSFET along with their individual ON resistances. In the figure, Rs is the diffusion and contact resistance of the source region, Rch the resistance of the induced channel region (induced MOSFET), Racc the overlap (accumulation) resistance of the gate and drain, Rdrift the resistance of the lightly doped drain region, and Rsub the resistance of the heavily doped drain region (substrate).

The MOSFET's ON resistance $R_{ON}$ is related to the resistances of the components shown in Figure 9 by following equation (1):

$$R_{ON} = Rs + Rch + Racc + Rdrift + Rsub \dots (1)$$

To achieve a large breakdown voltage (BVdss), the concentration of impurity introduced to the drift region generally needs be low. However, if the concentration is lowered, the Rdrift is increased, which in turn increases the ON resistance $R_{ON}$ of the MOSFET as a whole. So, there is a tradeoff between $R_{ON}$ and BVdss.

Conventional trench MOSFETs have depended on reduced cell pitches, as shown in Figure 10, to lower specific ON resistance. The breakdown voltage have been raised by optimizing the shape and depth of the trench as shown in Figure 11, for example. See the specification of U.S. Patent 5,168,331 (published December 1, 1992), for example. Figure 12 shows a MOSFET structure and doping profile which restricts decreases in the breakdown voltage on a trench corner. See, for example, the specification of U.S. Patent 4,893,160 (published January 9, 1990).

Some other conventional art documents about the trench MOSFET are Japanese Unexamined Patent Publication 8-23092/ 1996 (Tokukaihei 8-23092; published January 23, 1996) disclosing semiconductor devices and their manufacturing methods, Japanese Unexamined Patent Publication 11-354794/ 1999 (Tokukaihei 11-354794; published December 24, 1999) disclosing p-channel trench MOSFETs, and Japanese Unexamined Patent Publication 2003-324197 (Tokukai 2003-324197; published November 14, 2003) disclosing semiconductor devices and their manufacturing methods.

However, these trench MOSFET techniques of conventional art have following issues (a) to (c):

(a) Photolithography/etching steps presents obstacles in reducing the cell pitch, which is a primary approach to the reduction of ON resistance.
(b) The size of the trench MOSFET is dictated by the cell pitch, which is in turn dictated by the trench size and the contact size.
(c) To raise the breakdown voltage, a special trench shape and/or an additional manufacturing step are(is) needed. This will complicate the manufacturing process, increase manufacturing cost, and decrease productivity.

SUMMARY OF THE INVENTION

The present invention has an objective to provide a trench MOSFET structure which provides reduced ON resistance, increased breakdown voltage, and other improved characteristics required with trench MOSFETs without causing issues (a) to (c).

A trench MOSFET in accordance with the present invention, to achieve the objective, includes a trench region on a semiconductor substrate, the substrate containing: a heavily doped drain region of a first conduction type; a lightly doped drain region of the first conduction type; a channel body region of a second conduction type; and a source region of the first conduction type, the regions being formed in this order and adjacent to each other, the trench region being covered with, and insulated from, the source region.

In the trench MOSFET, the trench region is covered with the source region. This allows for the provision of larger contact region in the source region, which in turn reduces the ON resistance of the trench MOSFET. Further, margin restrictions are eliminated which would be otherwise required to arrange contacts in the source region and the trench along a straight line. Accordingly, smaller trench pitches are realized.

Another trench MOSFET in accordance with the present invention has a double gate trench structure in which a gate electrode and a lower electrode are provided in the trench region. The MOSFET can thus control the depletion layer in the drift region (lightly doped drain region), which in turn increases the breakdown voltage.

A more general effect realized by these effects is the realization of trench MOSFETs with reduced sizes and at reduced cost.

For a fuller understanding of the nature and advantages of the invention, reference should be made to the ensuing detailed description taken in conjunction with the accompanying drawings.

BRIEF DESCRIPTION OF THE DRAWINGS

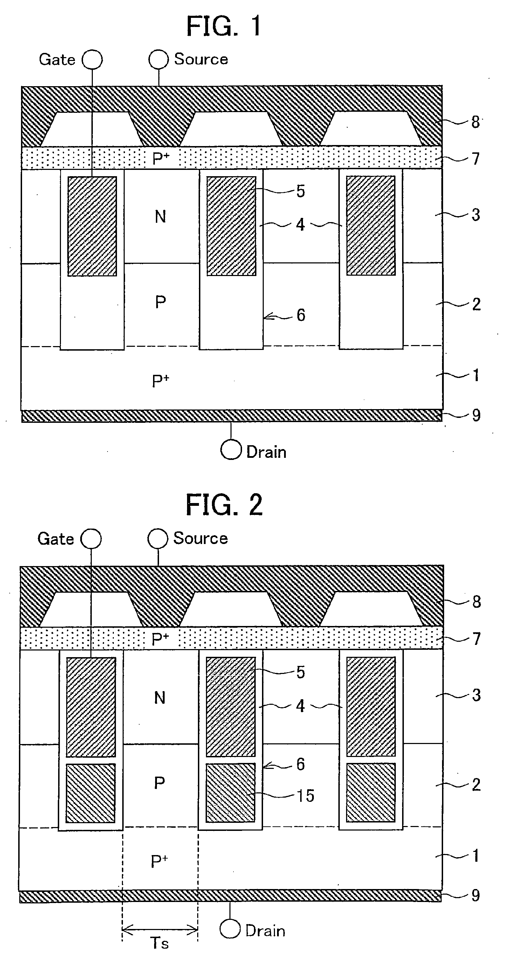

Figure 1 is a schematic cross-sectional view of a p-channel trench MOSFET which is an embodiment of the present invention.

Figure 2 is a schematic cross-sectional view of the structure of a trench MOSFET which is another embodiment of the present invention.

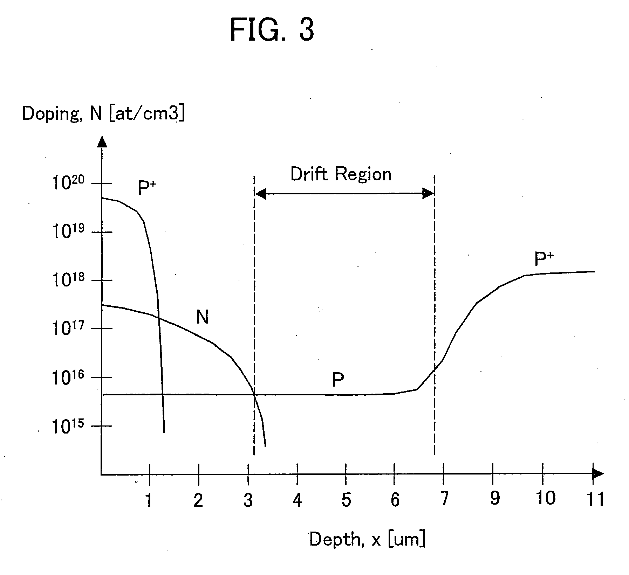

Figure 3 is a graphical representation of the impurity doping profile of a trench MOSFET in the vertical direction of an embodiment of the present invention.

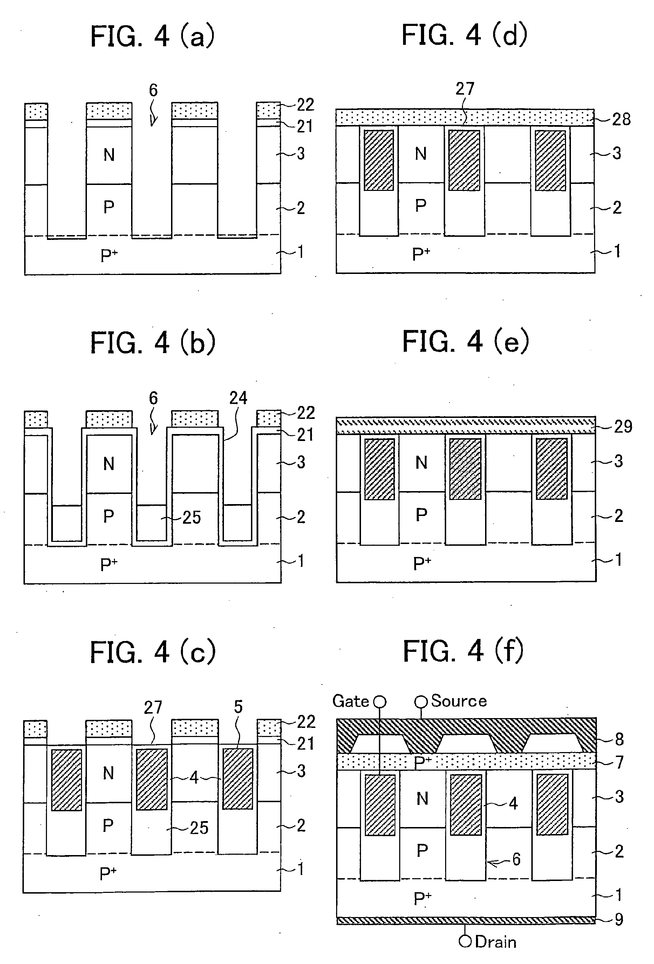

Figure 4(a) to Figure 4(f) are schematic cross-sectional views of the structure of a trench MOSFET of an embodiment of the present invention, illustrating the progress of manufacture of the trench MOSFET in successive stages.

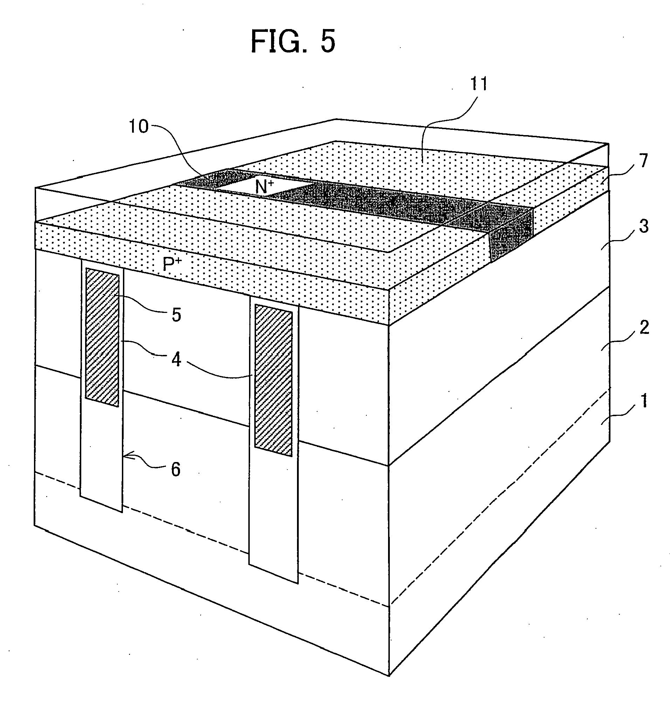

Figure 5 is a perspective view of a trench MOSFET, illustrating the arrangement of a channel body diffusion region 10 and a gate insulator which is a channel layer embedded in the trench MOSFET.

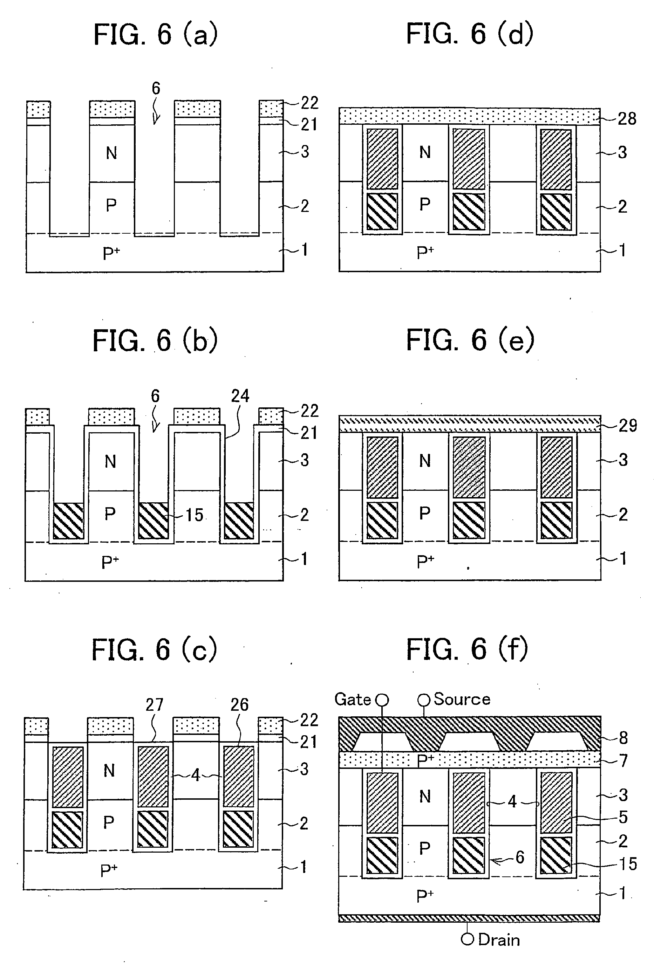

Figure 6(a) to Figure 6(f) are schematic cross-sectional views of the structure of a trench MOSFET of another embodiment of the present invention, illustrating the progress of manufacture of the trench MOSFET in successive stages.

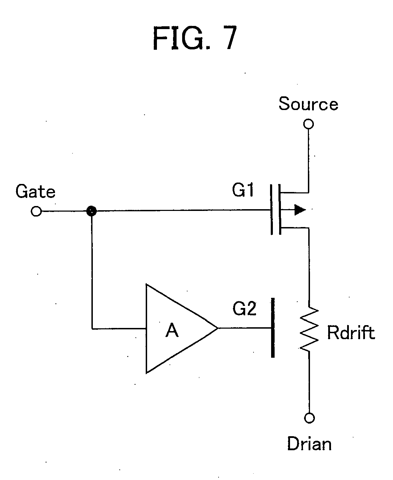

Figure 7 shows an equivalent driver circuit for the trench MOSFET of a double-gate structure shown in Figure 2.

Figure 8(a) to Figure 8(f) are schematic cross-sectional views illustrating manufacturing steps of a conventional trench MOSFET. Figure 8(a) depicts a stage where an Epi (n-epi) layer and a body region (diffusion region, p-base) are formed. Figure 8(b) depicts a stage where openings are formed through $SiO_2$. Figure 8(c) depicts a stage where a trench structure is formed in which the opening structure of Figure 8(b) defines an etching section. Figure 8(d) depicts a stage where polysilicon is deposited on the trench structure and etched back. Figure 8(e) depicts a stage where oxide is etched and $N^+$ (source region) and $P^+$ (body region) are implanted. Figure 8(f) depicts a stage where an interlayer insulator (interlevel dielectric deposition) is deposited and subjected to metalization.

Figure 9 is a cross-sectional view of the structure of a conventional p-channel trench MOSFET along with ON resistances of its components.

Figure 10 is a cross-sectional view of the repeated structure and cell pitch of a conventional p-channel trench MOSFET.

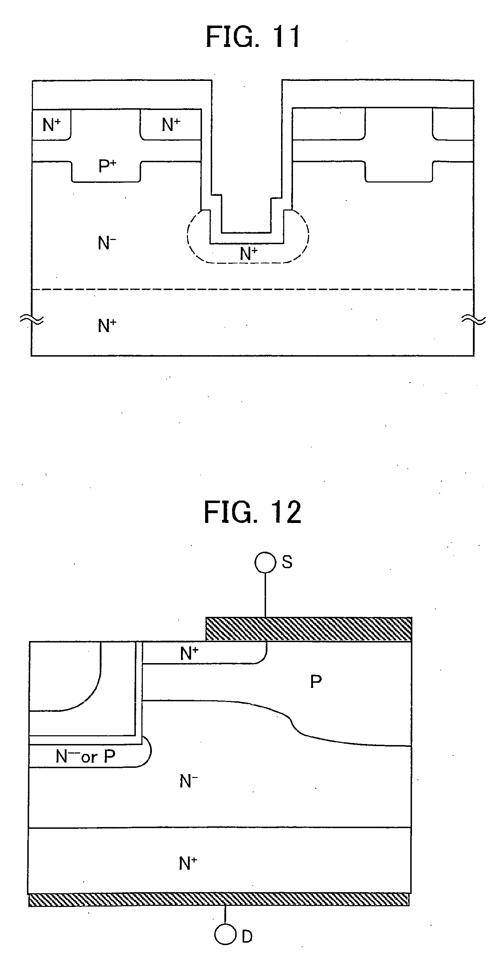

Figure 11 is a cross-sectional view of the structure of a conventional p-channel trench MOSFET which exhibits increased breakdown voltage owing to optimized trench depth and shape.

Figure 12 is a cross-sectional view of a MOSFET structure and doping profile which restricts decreases in the breakdown voltage on a trench corner.

DESCRIPTION OF THE EMBODIMENTS

Under this heading, a novelty trench MOSFET and its manufacturing method will be described according to the present invention. The present embodiment will focus on the present invention being applied to a p-type trench MOSFET. One with ordinary skill in the art would appreciate that the present invention is applicable not only to p-type trench MOSFETs, but also to n-type trench MOSFETs.

[Embodiment 1]

The trench MOSFET of the present embodiment is a trench MOSFET formed on a semiconductor substrate. The MOSFET has a heavily doped drain region, a lightly doped drain region (drift region), a channel body region, a heavily doped source region, a MOSFET gate inducing channel, and a trench region. The heavily doped drain region is of a first conduction type (p-type in the present embodiment) and formed on the back of a semiconductor wafer (in the present embodiment, the "semiconductor wafer" or "wafer" refers to a device on which trench MOSFETs are formed where appropriate). The lightly doped drain region is of the first conduction type and formed in contact with the heavily doped drain region. The channel body region is of a second conduction type (n-type in the present embodiment) and formed between the lightly doped drain region and a source region. The heavily doped source region is of the first conduction type and formed on top of the semiconductor substrate so that the region is in contact with the channel body region. The MOSFET gate inducing channel is formed on a vertical wall of the trench region. The trench region extends downward from the top face of the semiconductor substrate. The bottom of the trench region reaches and penetrates the lightly doped drain region. The trench region is covered by the source region on top of the semiconductor substrate. The channel length of the vertical trench MOSFET is defined by the depth of the channel body region of the second conduction type and the junction depth of the source region of the first conduction type. On the vertical wall of the trench region is deposited or grown a gate insulator. In the trench region, a gate electrode is deposited which is isolated from the semiconductor substrate by the gate insulator. The heavily doped source region, formed as a continuous semiconductor layer, is isolated by the insulator from the trench region and the gate electrode embedded in the trench region.

An embodiment of the present invention will be now described in reference to figures.

Figure 1 is a schematic cross-sectional view of the structure of a trench MOSFET which is embodiment 1 of the present invention. An epitaxial layer (lightly doped drain region) 2, acting as a drift region, is formed on a heavily doped substrate (heavily doped drain region) 1. A body region (channel body region) 3 of the trench MOSFET is of an opposite polarity to a drift region 2. A gate electrode 5 and a gate insulator (gate inducing channel) 4 induces the trench MOSFET. A source diffusion region (source region) 7 is in contact with an upper metal layer 8. A drain 9 is formed on the bottom (opposite the upper metal layer 8) of the trench MOSFET by metalization. Throughout the rest of the present embodiment, the top side of a layer refers to the one closer to the upper metal layer 8, and the bottom side to the one closer to the drain 9.

In the trench MOSFET of the present embodiment, the substrate 1, the epitaxial layer 2, the body region 3, and the source diffusion region 7 are layered in this sequence to constitute a semiconductor substrate. A trench region 6 is formed through the body region 3 and the epitaxial layer 2 to reach the substrate 1. The top end of the trench region 6 is covered with the source diffusion region 7. A pitch between adjacent trench regions 6 and the concentration of impurity dopant in the epitaxial layer (drift region) 2 dictate a property of the epitaxial layer 2, i.e., RESURF.

The source diffusion region 7 is provided to cover the top of the trench region 6, allowing for volume expansion of the source diffusion region 7, hence for reduced source diffusion resistance. This continuous or elevated source structure of the source diffusion region 7 can be constructed using, for example, Si epitaxis.

Figures 4(a) to 4(f) are schematic cross-sectional views of the structure of a trench MOSFET of an embodiment of the present invention, illustrating the progress of manufacture of the trench MOSFET in successive stages.

First, the unprocessed, silicon substrate 1 is typically p-type doped to achieve a resistivity between 0.01 $\Omega{\cdot}$cm to 0.005 $\Omega{\cdot}$cm and has a thickness from 500 $\mu$m to 650 $\mu$m. After the trench MOSFET is fabricated, the substrate 1 is thinned down to about 100 $\mu$m to 150 $\mu$m by back lapping.

The epitaxial layer (Epi layer) 2 is formed by epitaxially growing a P layer on the $P^+$ substrate 1; the P layer being less doped than the substrate 1. The thickness Xepi and resistance $\rho$ epi of the epitaxial layer 2 thus formed may be specified depending on the ultimate electrical characteristics the trench MOSFET is required to posses. In typical cases, the resistance of the epitaxial layer 2 should be lowered to decrease the ON resistance of the trench MOSFET; however, there is a tradeoff between the resistance of the epitaxial layer 2 and the breakdown voltage. A typical, vertical doping profile of the trench MOSFET of the present embodiment is shown in Figure 3.

The body region 3 of the trench MOSFET of the present embodiment is of n-type. The body region 3 is formed by implanting phosphor atoms so that the top surface of the silicon has a dopant concentration from $5\times10^{16}$ to $7\times10^{17}$ atoms/cm$^3$. The n-type body region 3 is designed to form a PN junction with the epitaxial layer 2 at a depth Xn from 2 $\mu$m to 5 $\mu$m. The values may vary depending on the electrical characteristics of the trench MOSFET. For example, the device operates at 40 V, the epitaxial layer 2 is typically designed for an Xn from 2.5 $\mu$m to 3 $\mu$m.

A SiGe layer may be grown to provide a desired increased hole mobility to the epitaxial layer (drift region) 2. The epitaxial SiGe layer 2 may be formed by repeated depositions. For example, the layer 2 may be formed in a gaseous mixture of $SiH_6$ and $GeH_4$ using a CVD reactant which will be deposited vertically.

Suitable control of the quantity of Ge in the SiGe layer can yield a strained Si layer, resulting in increases in the hole mobility of the epitaxial layer 2.

As shown in Figure 4(a), a $SiO_2$ layer 21 and a CVD oxide layer 22 are deposited on the body region 3, forming topmost layers of the wafer. These $SiO_2$ layer 21 and CVD oxide layer 22 are patterned by a publicly known photoetching technique to define the trench region 6. This stack of the $SiO_2$ layer 21 and the CVD oxide layer 22 is used as an etching mask in the etching of the substrate 1, the epitaxial layer 2, and the body region 3 to form the trench region 6.

In the trench MOSFET of the present embodiment, the depth of the trench region 6 is typically from about 1.5 μm to about 5 μm. The depth of the channel region (channel body) is a little less than the depth of the trench region 6. The width of the trench region 6 is typically from 0.5 μm to 3 μm. The bottom of the trench region 6 is positioned at substantially the same place as the interface between the epitaxial layer 2 and the substrate 1. The trench region 6 is partly surrounded by the drift region.

Referring to Figure 4(a), after the trench region 6 is etched out, a surface oxide ($SiO_2$) is thermally grown to 5 nm to 10 nm. The surface oxide is then removed. These steps eliminate defects which occurred on the surface of the semiconductor in the vertical direction in the etching step which formed the trench region 6. Subsequently, in the present embodiment, $SiO_2$ is thermally grown on the side face of the trench region 6 to a thickness of 5 nm to 10 nm. In this manner, the $SiO_2$ layer 24 is formed on the side face of the trench region 6. The trench region 6 is then filled with a CVD oxide 25. Thereafter, the CVD oxide 25 is etched back to leave some of it only on the bottom of the trench region 6, as shown in Figure 4(b). In the present embodiment, the CVD oxide 25 is etched back to leave the CVD oxide 25 deposited in the trench region 6 to a level a little way down toward the substrate 1 from the interface between the epitaxial layer 2 and the body region 3.

After removing the $SiO_2$ layer 24, a gate oxide ($SiO_2$) is grown to a thickness which suits a maximum operating voltage of the trench MOSFET. Thereafter, the trench region 6 is filled with a material from which the gate electrode 5 will be fabricated. In the present embodiment, a typical material, polysilicon, is used for the gate electrode 5. In addition, $POCl_3$ along with phosphor is used to dope the polysilicon.

After the doping, to remove the polysilicon from the flat surface of the wafer, the polysilicon is subjected to planarization. Accordingly, the polysilicon which will be the gate electrode 5 is left only to fill up the trench region 6. After removing the stack of the $SiO_2$ layer 21 and the CVD oxide layer 22 shown in Figure 4(c), the entire wafer is oxidized to cover the top of the polysilicon gate electrode 5 with an oxide layer 27 to isolate the gate electrode 5. For convenience in description, the $SiO_2$ layer 21 and the CVD oxide layer 22 are both shown in Figure 4(c) with the oxide layer 27 on the gate electrode 5. Actually, however, the epitaxial layer 21 and the CVD oxide layer 22 are not present on the wafer when the oxide layer 27 are provided.

Subsequently, as shown in Figure 4(d), an undoped amorphous Si layer 28 is stacked on top of the wafer (opposite the substrate 1). The amorphous Si layer 28 is crystallized in solid state in about 12-hour thermal processing at 550°C to 600°C in a nitrogen gas atmosphere. The amorphous Si layer 28 is crystallized in the processing because it is in contact with Si. The Si in contact with the amorphous Si layer 28 is the body region 3. Consequently, the amorphous Si layer 28 is crystallized to form a Si layer 29 on the topmost layer of the trench region 6 (the outermost layer opposite the substrate 1; see Figure 4(e)).

After obtaining the wafer shown in Figure 4(e) through the above fabrication, the upper metal layer 8 and drain 9 are formed by a publicly known method. The epitaxial layer 29 is turned into a p-type source diffusion region 7 to complete the fabrication of the trench MOSFET of the present embodiment as shown in Figure 4(f).

Figure 5 is a schematic perspective view of a trench MOSFET, illustrating the arrangement of a channel body diffusion region 10. The source diffusion region 7 and the channel body diffusion region 10 can be formed with a method involving publicly well-known photoresist masking and ion implantation. The p+ source diffusion region 7 is formed by implanting a p-type dopant ($^{11}B^+$ or $BF_2^+$) to a concentration (dose) of about $1 \times 10^{15}$ to $3 \times 10^{15}$ so that a PN junction forms at a depth of 0.2 μm to 0.5 μm. Similarly, the channel body diffusion region 10 is formed by implanting a n-type dopant ($^{31}P^+$ or $^{75}As^+$) to a concentration of about $1 \times 10^{15}$ to $3 \times 10^{15}$ so that a junction forms at a depth of 0.2 μm to 0.5 μm.

These steps may be replaced with a silicidation step on the p-type source diffusion region 7 and the n-type channel body diffusion region 10.

Lastly, an interlayer insulator layer, contacts 11, and an upper metal layer 8 are formed by a conventional, publicly known manufacturing method for typical IC devices.

After the wafer is thinned down to 100 μm to 150 μm by back lapping, the backside of the wafer (the substrate 1) is subjected to metalization stacking and turned into alloy in 10-minute processing in a forming gas at 430°C.

As described in the foregoing, the device of the present embodiment is provided with the continuous source diffusion region 7 expanding across the wafer, hence reduced source diffusion resistance. To further lower the source diffusion resistance, the source diffusion region may be made of a silicon compound.

[Embodiment 2]

The following will be described a trench MOSFET as embodiment 2 of the present invention in reference to figures. Here, for convenience, members of the present embodiment that have the same arrangement and function as members of the previous embodiment, and that are mentioned in that embodiment are indicated by the same reference numerals and description thereof is omitted.

Figure 2 is a schematic cross-sectional view of the trench MOSFET of the present embodiment. As shown in the figure, the trench MOSFET of the present embodiment differs from the previous embodiment in that there is provided a lower electrode 15 under the gate electrode 5 in the trench region 6. Otherwise, the trench MOSFET has the same structure as the one described in reference to Figure 1.

The gate electrode 5 in the trench region 6 is to control the induction of a channel in the body region 3. The lower electrode 15 is to control the epitaxial layer 2 which is a drift region. The lower electrode 15 placed inside the trench region 6 where the electrode 15 will be surrounded by the epitaxial layer 2. The structure enables voltage to be applied vertically from the gate electrode 5, as well as horizontally from the lower electrode 15, to the epitaxial layer 2. Accordingly, the total electric field at the place where the epitaxial layer 2 is present can be reduced. This provision of the lower electrode 15 limits occurrence of voltage tolerance defects in the epitaxial layer 2.

The manufacturing steps for the MOSFET in Figure 2 will be now described in reference to Figure 6(a) to Figure 6(f) which are schematic cross-sectional views of the trench MOSFET, illustrating the progress of manufacture of the trench MOSFET of the present embodiment in successive stages.

Referring to Figure 6(a), after the trench region 6 is etched out, a surface oxide ($SiO_2$) is thermally grown to 5 nm to 10 nm. The surface oxide is then removed. These steps eliminate defects which occurred on the surface of the semiconductor in the vertical direction in the etching step which formed the trench region 6. Subsequently, in the present embodiment, $SiO_2$ is thermally grown on the side face of the trench region 6 to a thickness of 5 nm to 10 nm. In this manner, the $SiO_2$ layer 24 is formed on the side face of the trench region 6. Polysilicon (PolySi) is then deposited inside the trench region 6. The polysilicon is etched back to leave some of it only on the bottom of the trench region 6 as shown in Figure 6(b), to form the lower electrode 15.

In the present embodiment, the polysilicon is etched back to leave the polysilicon deposited in the trench region 6 to a level a little way down toward the substrate 1 from the interface between the epitaxial layer 2 and the body region 3, to form the lower electrode 15. The polysilicon making up the lower electrode 15 is doped together with a n- or p-type impurity. In this manner, in the present embodiment, the CVD oxide 25 is replaced by the lower electrode 15, made of polysilicon, on the bottom of the trench region 6 (closer to the bottom than the gate electrode 5).

After removing the $SiO_2$ layer 24, a gate oxide ($SiO_2$) is grown to a thickness which suits a maximum operating voltage of the trench MOSFET. Thereafter, the trench region 6 is filled with a material from which the gate electrode 5 will be fabricated. In the present embodiment, a typical material, polysilicon, is used for the gate electrode 5. In addition, $POCl_3$ along with phosphor is used to dope the polysilicon.

After the doping, to remove the polysilicon from the flat surface of the wafer, the polysilicon is subjected to planarization. Accordingly, the polysilicon which will be the gate electrode 5 is left only to fill up the trench region 6. After removing the stack of the $SiO_2$ layer 21 and the CVD oxide layer 22 shown in Figure 6(c), the entire wafer is oxidized to cover the top of the polysilicon gate electrode 5 with an oxide layer 27 to isolate the gate electrode 5.

Subsequently, as shown in Figure 6(d), an undoped amorphous Si layer 28 is stacked on top of the wafer (opposite the substrate 1). The amorphous Si layer 28 is crystallized in solid state in about 12-hour thermal processing at 550°C to 600°C in a nitrogen gas atmosphere. The amorphous Si layer 28 is crystallized in the processing because it is in contact with Si. Consequently, the amorphous Si layer 28 is crystallized to form a Si layer 29 on the topmost layer of the trench region 6 (the outermost layer opposite the substrate 1; Figure 6(e)).

After obtaining the wafer shown in Figure 6(e) through the above fabrication, the upper metal layer 8 and drain 9 are formed by a publicly known method. The epitaxial layer 29 is turned into a p-type source diffusion region 7 to complete the fabrication of the trench MOSFET of the present embodiment as shown in Figure 6(f).

As described in the foregoing, in the trench MOSFET of the present embodiment, the epitaxial layer 2 which is a drift region is surrounded by the trench region 6. Accordingly, depletion in the drift region 6 and electric fields on the side face are controllable through the lower electrode 15 embedded in the trench region 6. This limitations on the electric field strength by means of the lower electrode 15 imparts the trench MOSFET of the present invention with high breakdown voltage.

To achieve these effects, both a trench region 6 interval Ts (see Figure 2) and a dopant concentration Ndrift in the drift region are preferably optimized. Generally, preferably, $3 \times 10^{11}$ (atoms/cm$^2$) $\leq$ Ndrift $\times$ Ts $\leq$ $3 \times 10^{12}$ (atoms/cm$^2$). More preferably, Ndrift $\times$ Ts is about $10^{12}$ atoms/cm$^2$.

The trench MOSFET of the present embodiment differs from the previous embodiment in that it has a double-gate structure where two gate electrodes are provided with one on top of the other. The MOS transistor channel formed by inverting the surface of the body region 3 is controlled through the upper one of the two-tiered gate electrodes, i.e., the gate electrode 5. The lower one of the gate electrodes, i.e., the lower electrode 15, may be connected to a different voltage source from, or the same voltage source as, the upper gate electrode 5. The lower electrode 15 serves to deplete the epitaxial layer 2 to create a wide electric field section in OFF state. This increases the breakdown voltage of the trench MOSFET.

If the polysilicon, lower electrode 15 is connected directly to the gate electrode 5, the overlapping gate and drain has an increased capacitance, leading to greater Miller effect. To avoid such problems, it is preferable if the polysilicon, lower gate electrode 15 is coupled, as shown in Figure 7, to an output of a unity-gain buffer amplifier driven by main gate voltage.

In Figure 7, G1 indicates the gate electrode 5, and G2 the lower electrode 15. "A" indicates an amplifier which drives G2 by the electric potential associated with the voltage input to the gate electrode 5 (G1) (in the present embodiment, the electric potential is proportional to the voltage input to G1).

As described in the foregoing, the trench MOSFET of the present invention primarily employs the following technical approaches (a), (b) and a combination of them to reduce the ON resistance of the trench MOSFET.

(a) To reduce the source diffusion resistance, the source region is formed to cover the upper part of the trench region.
(b) The drift region is provided to limit the electric field strength in a vertical direction.

Further, the source region, provided to cover the trench region, allows for reductions in the cell pitch of the trench MOSFET. The transistor can be reduced in size.

A trench MOSFET of the present invention, to solve the problems, includes a trench region on a semiconductor substrate, the substrate containing: a heavily doped drain region of a first conduction type; a lightly doped drain region of the first conduction type; a channel body region of a second conduction type; and a source region of the first conduction type, the regions being formed in this order and adjacent to each other, the trench region being covered with, and insulated from, the source region.

The structure eliminates restrictions on contacts in the source region, which in turn increases density, lowers the ON resistance, and improves other characteristics of the trench MOSFET. Specifically, the source region covers and is isolated from the trench region; the structure reduces the ON resistance.

In conventional trench MOSFETs, as shown in Figure 10, the trench region divides the source region on the substrate surface; a hole is needed for each divided source region so that each region has its own source contact. In contrast, in the trench MOSFET of the present invention, the source region is provided as a continuous plane covering the trench region. The structure eliminates restrictions on positions of contact holes to the source region. The structure allows for increased density with a process which involves lenient rules.

In other words, in the trench MOSFET of the present invention, the trench region is covered with the source region. Therefore, the MOSFET has no design (and step) restrictions in the formation of conventional contact holes, and needs no process as fine as conventional MOSFETs. Accordingly, manufacturing cost can be reduced when compared to conventional MOSFETs.

In addition, the channel body region has a body contact region for providing electric potential to the channel body region. When using the trench MOSFET of the present invention as a power element, the body contact region may be at a different electric potential from the source region, although the body contact region is generally at the same electric potential as the source region.

The structure insulating the trench region from the source region is not limited in any particular manner. For example, a gate insulating layer may be provided between the regions. The "first conduction type" and the "second conduction type" refer to positive and negative types or vice versa. The trench MOSFET of the present invention may be either a p-type trench MOSFET or a n-type trench MOSFET.

Preferably, the trench region extends through the channel body region and the lightly doped drain region, reaching the heavily doped drain region; there is provided a gate electrode for controlling channel conduction in a part surrounded by the channel body region; and there is provided an insulator region in a part surrounded by the lightly doped drain region.

The structure restrains occurrence of junction breakdown near the bottom of the trench region. Specifically, the insulator region provided below the gate electrode in the trench region limits the strength of an electric field, thereby preventing junction breakdown near the bottom of the trench region and improving voltage tolerance. Accordingly, the trench MOSFET has an increased breakdown voltage.

In this structure of the trench region provided with a gate electrode and an insulator region, the top of the semiconductor substrate is preferably separated by substantially equal distances from the bottom of the gate electrode and from the interface plane between the heavily doped drain region and the lightly doped drain region.

Accordingly, the control of channel conduction through the gate electrode and the prevention of junction breakdown in the insulator region can be efficiently realized. In the present invention, the bottom of the gate electrode refers to the end of the gate electrode on the bottom end of the trench region. Also, two distances are "substantially equal" when any one of them is 0.9 times to 1.1 times the other distance.

Preferably, the trench region extends through the heavily doped drain region and the lightly doped drain region, reaching the channel body region; there is provided an upper gate electrode for controlling channel conduction in a part surrounded by the heavily doped drain region; and there is provided a lower electrode electrically separated from the upper gate electrode in a part surrounded by the lightly doped drain region.

The structure restrains occurrence of junction breakdown near the bottom of the trench region. Specifically, the lower electrode provided below the gate electrode in the trench region and electrically separated from the gate electrode enables application of an electric field to the lightly doped drain region which is a drift region in a direction vertical to the depth direction of the drift region (horizontally). Accordingly, when compared to the application of an electric field only in the depth direction (vertical) of the trench region to the lightly doped drain region, the total electric field at the position (point) of the lightly doped drain region can be reduced (in terms of vector). Voltage tolerance improves near the bottom of the trench region. Accordingly, the trench MOSFET has an increased breakdown voltage.

In a conventional trench MOSFET, as shown in Figure 10, a P/N junction is formed between a channel body region and a drift region (lightly doped drain region). A junction breakdown (voltage tolerance defect) may occur in the junction region and near the bottom of the trench region. The junction breakdown is caused by a strong vertical electric field in those parts. As discussed earlier, the present invention reduces the vertical electric field to restrain the junction breakdown.

When providing the trench region with a lower electrode, an output of an amplifier electrically driving the lower electrode may be associated with a voltage applied to the upper gate electrode.

The "association" between the amplifier output and the voltage applied to the upper gate electrode may be, for example, such that the amplifier output may be proportional to the voltage applied to the upper gate electrode. The association is however not limited to this example. Any association is possible.

The trench region may have a vertical wall on which a gate inducing channel is formed. The trench MOSFET may have a channel length defined by the difference between the depth of the channel body region and the junction depth of the source region.

The "difference between the depth of the channel body region and the junction depth of the source region" refers to the difference between the distance from the surface of the substrate on a side thereof on which the trench region is provided to the junction region between the channel body region and the lightly doped drain region and the distance from that surface to the junction region between the channel body region and the source region. In other words, the difference refers to the width of the channel body region in a depth direction of the trench region.

The trench MOSFET of the present invention may be such that the semiconductor substrate is made of silicon or such that the lightly doped drain region is made of epitaxial SiGe. The SiGe improves carrier mobility in the lightly doped drain region, which lowers the ON resistance of the trench MOSFET.

Preferably, $3 \times 10^{11}$ (atoms/cm$^2$) $\leq$ Ts $\times$ Ndrift $\leq 3 \times 10^{12}$ (atoms/cm$^2$) where Ndrift is the impurity doping level in the lightly doped drain region, and Ts is the interval between trench regions.

By fabricating the lightly doped drain region so that the interval, Ts, between trench regions and the impurity doping level Ndrift meet the above relationship, the breakdown voltage can be increased. The interval, Ts, between trench regions refers to the distance separating the side wall of a trench region from the side wall of an adjacent one. In other words, the interval refers to the interval between lightly doped drain regions flanked by trench regions.

The trench MOSFET of the present invention discussed so far is manufactured by a method of manufacturing a trench MOSFET including a trench region on a semiconductor substrate, the substrate containing: a heavily doped drain region of a first conduction type; a lightly doped drain region of the first conduction type; a channel body region of a second conduction type; and a source region of the first conduction type, the regions being formed in this order and so that adjacent regions are in contact with each other, the method including the sequential steps of: forming an insulating film on the trench region; providing an amorphous silicon layer on the trench region on which the insulating film is formed and on the channel region; and crystallizing the amorphous silicon layer, to form the source region.

The amorphous silicon may be crystallized by thermal processing in an atmosphere of an inactive gas. The inactive gas may be nitrogen gas, and the thermal processing may be carried out at an ambient temperature of 550°C to 600°C, inclusive.

The trench MOSFET of the present invention is manufactured by a method of manufacturing a trench MOSFET including a trench region on a semiconductor substrate, the substrate containing: a heavily doped drain region of a first conduction type; a lightly doped drain region of the first conduction type; a channel body region of a second conduction type; and a source region of the first conduction type, the regions being formed in this order and so that adjacent regions are in contact with each other, the method including the sequential steps of: forming an insulating film on the trench region; and providing a polysilicon layer on the trench region on which the insulating film is formed and on the channel region, to form the source region.

The invention being thus described, it will be obvious that the same way may be varied in many ways. Such variations are not to be regarded as a departure from the spirit and scope of the invention, and all such modifications as would be obvious to one skilled in the art are intended to be included within the scope of the following claims.

The embodiments and examples described in *Best Mode for Carrying Out the Invention* are for illustrative purposes only and by no means limit the scope of the present invention. Variations are not to be regarded as a departure from the spirit and scope of the invention, and all such modifications as would be obvious to one skilled in the art are intended to be included within the scope of the claims below.

**Claims**

1.  A trench MOSFET, comprising a trench region on a semiconductor substrate,
    the substrate containing: a heavily doped drain region of a first conduction type; a lightly doped drain region of the first conduction type; a channel body region of a second conduction type; and a source region of the first conduction type, the regions being formed in this order and adjacent to each other,
    the trench region being covered with, and insulated from, the source region.

2.  The trench MOSFET of claim 1, wherein:

    the trench region extends through the channel body region and the lightly doped drain region to the heavily doped drain region;
    there is provided a gate electrode for controlling channel conduction in a part surrounded by the channel body region; and
    there is provided an insulator region in a part surrounded by the lightly doped drain region.

3.  The trench MOSFET of claim 2, wherein a top of the semiconductor substrate is separated by substantially equal distances from a bottom of the gate electrode and from an interface between the heavily doped drain region and the lightly doped drain region.

4.  The trench MOSFET of claim 1, wherein:

    the trench region extends through the heavily doped drain region and the lightly doped drain region to the channel body region;
    there is provided an upper gate electrode for controlling channel conduction in a part surrounded by the heavily doped drain region; and
    there is provided a lower electrode electrically separated from the upper gate electrode in a part surrounded by the lightly doped drain region.

5.  The trench MOSFET of claim 4, wherein an output of an amplifier electrically driving the lower electrode is associated with a voltage applied to the upper gate electrode.

6.  The trench MOSFET of claim 1, wherein the trench region has a vertical wall on which a gate inducing channel is formed.

7.  The trench MOSFET of claim 1, having a channel length defined by a difference between a depth of the channel body region and a junction depth of the source region.

8.  The trench MOSFET of claim 1, wherein the semiconductor substrate is made of silicon.

9.  The trench MOSFET of claim 1, wherein the lightly doped drain region is made of epitaxial SiGe.

10. The trench MOSFET of claim 1, wherein

$$3 \times 10^{11} \ (\text{atoms/cm}^2) \ \leq \ Ts \ \times \ Ndrift \ \leq \ 3 \times 10^{12}$$

$$(\text{atoms/cm}^2)$$

11. A method of manufacturing a trench MOSFET including a trench region on a semiconductor substrate,
    the substrate containing: a heavily doped drain region of a first conduction type; a lightly doped drain region of the first conduction type; a channel body region of a second conduction type; and a source region of the first conduction type, the regions being formed in this order and so that adjacent regions are in contact with each other,
    the method comprising the sequential steps of:

    forming an insulating film on the trench region;
    providing an amorphous silicon layer on the trench region on which the insulating film is formed and on the channel region; and

crystallizing the amorphous silicon layer, to form the source region.

12. The method of claim 11, wherein the amorphous silicon is crystallized by thermal processing in an atmosphere of an inactive gas.

13. The method of claim 12, wherein:

the inactive gas is nitrogen gas; and

the thermal processing is carried out at an ambient temperature of 550°C to 600°C, inclusive.

14. A method of manufacturing a trench MOSFET including a trench region on a semiconductor substrate, the substrate containing: a heavily doped drain region of a first conduction type; a lightly doped drain region of the first conduction type; a channel body region of a second conduction type; and a source region of the first conduction type, the regions being formed in this order and so that adjacent regions are in contact with each other, the method comprising the sequential steps of:

forming an insulating film on the trench region; and

providing a polysilicon layer on the trench region on which the insulating film is formed and on the channel region, to form the source region.

# FIG. 1

Gate ◯　　◯ Source

N

P

P⁺

◯ Drain

8

7

5

4

3

6

2

1

9

# FIG. 2

Gate ◯　　◯ Source

N

P

P⁺

◯ Drain

8

7

5

4

3

6

15

2

1

9

Ts

# FIG. 3

Doping, N [at/cm3]

Drift Region

$10^{20}$  P+

$10^{19}$

$10^{18}$  P+

$10^{17}$  N

$10^{16}$  P

$10^{15}$

Depth, x [um]

## FIG. 4 (a)

## FIG. 4 (b)

## FIG. 4 (c)

## FIG. 4 (d)

## FIG. 4 (e)

## FIG. 4 (f)

# FIG. 5

# FIG. 6 (a)

# FIG. 6 (d)

# FIG. 6 (b)

# FIG. 6 (e)

# FIG. 6 (c)

# FIG. 6 (f)

# FIG. 7

## FIG. 8 (a)

p-base

n-epi

n$^+$-substrate

## FIG. 8 (d)

p

n

n$^+$

## FIG. 8 (b)

p

n

n$^+$

## FIG. 8 (e)

p$^+$  n$^+$  n$^+$  p$^+$

p  p

n

n$^+$

## FIG. 8 (c)

p

n

n$^+$

## FIG. 8 (f)

S

p$^+$  n$^+$  n$^+$  p$^+$

p  p

n

n$^+$

D

# FIG. 9

Gate ⃝      ⃝ Source

Rs

P

Rch   N   Body

Racc

Rdrift   P   Drift

Rsub   P   Substrate

⃝ Drain

# FIG. 10

Gate ⃝   ⃝ Source

Pitch

P⁺

N

P

P⁺

⃝ Drain

# FIG. 11

# FIG. 12